# EUROPEAN PATENT APPLICATION

(11) **EP 4 663 821 A1**
(43) Date of publication of application: **17.12.2025**
(21) Application number: 23921311.9
(22) Date of filing: 21.11.2023
(51) Int. Cl.: C30B 29/04, C23C 16/02, C23C 16/27, H01L 21/205

(54) **NICKEL SUBSTRATE AND METHOD FOR MANUFACTURING DIAMOND SUBSTRATE USING SAME**

(30) Priority: 10.02.2023 JP 2023019115
(71) Applicant: National University Corporation Kanazawa University, Ishikawa 920-1192 (JP); SHIN-ETSU CHEMICAL CO., LTD., Tokyo 1000005 (JP)
(72) Inventor: TOKUDA, Norio, Kanazawa-shi, Ishikawa 920-1192 (JP); YAMASAKI, Satoshi, Kanazawa-shi, Ishikawa 920-1192 (JP); MATSUMOTO, Tsubasa, Kanazawa-shi, Ishikawa 920-1192 (JP); MIKOSHIBA, Naoki, Kanazawa-shi, Ishikawa 920-1192 (JP); ASAI, Taiga, Echizen-shi, Fukui 915-8515 (JP)
(74) Representative: Wunderlich & Heim Patentanwälte PartG mbB
(86) International application number: PCT/JP2023/041736
(87) International publication number: WO 2024/166491

(57) **Abstract**

An object is to provide a nickel substrate to be used for obtaining a large-diameter diamond substrate, and to provide a method for producing a diamond substrate using the same. Provided is a nickel substrate to be used for heteroepitaxially growing a diamond layer, and the nickel substrate consists of a single crystal, and has a (111) crystal plane on a surface thereof.

## Description

### TECHNICAL FIELD

The present invention relates to a nickel substrate to be used for heteroepitaxially growing a diamond layer, and a method for producing a diamond substrate using this nickel substrate.

### BACKGROUND ART

Diamond is a power semiconductor material, and is expected also as a quantum material operating at room temperature.

While diamond possesses a larger bandgap, higher insulation properties, and greater thermal conductivity than wide bandgap semiconductors such as SiC and GaN, it is technically difficult to obtain a freestanding diamond substrate of 4 inches or more.

For example, German startup, Audiatec has developed a technology to grow single crystal diamond using microwave plasma CVD on an Ir layer, which is formed via YSZ (yttria stabilized zirconia) on a Si substrate, and is now selling a diamond single crystal.

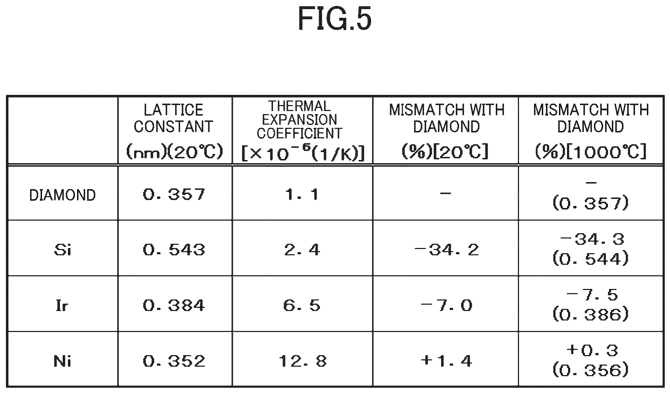

This is because while large-diameter Ir substrates have not been obtained, large-diameter Si substrates of 6 inches or more can be obtained. As illustrated in a physical property comparison table of FIG. 5, there is a significant difference in lattice constant between Si and diamond, and hence, considerable strain is caused by lattice mismatch, and therefore, it is necessary to form an Ir layer via a YSZ layer to mitigate the strain with a diamond layer subsequently grown heteroepitaxially thereon.

In contrast, a Ni substrate has lattice mismatch with diamond of only about 1% at 20°C, and has greater thermal expansion than diamond, and hence it can be predicted that by increasing the temperature for the heteroepitaxial growth of a diamond layer, the lattice mismatch with the diamond layer can be further reduced.

Focusing on this point, the present inventors have proposed a method for producing diamond using a nickel substrate (Patent Document 1).

In recent years, as described in Non Patent Document 1, for example, large-diameter Ni substrates of 4 inches, 6 inches, and even larger have begun to be proposed, and therefore, attempts have made to grow a diamond layer using such a large-diameter single crystal Ni substrate based on the invention described in Patent Document 1, but only an amorphous carbon layer or a polycrystalline diamond layer with low orientation could be formed on the large-diameter single-crystal Ni substrate as it was..

### RELATED-ART DOCUMENT

### PATENT DOCUMENT

Patent Document 1: JP-B-6561402

### NON-PATENT DOCUMENT

Non Patent Document 1: "Crystal growth of 8 inch diameter Ni single crystal for GaN substrate", Kazuya Takahashi et al., Abstracts of 81st Japan Society of Applied Physics Autumn Meeting, 2020, 8p-Z14-3

### SUMMARY OF THE INVENTION

### TECHNICAL PROBLEM

An object of the invention is to provide a nickel substrate for obtaining a large-diameter diamond substrate, and a method for producing a diamond substrate using the same.

### SOLUTION TO PROBLEM

According to a first aspect of the invention, there is provided a nickel substrate to be used for heteroepitaxially growing a diamond layer, the nickel substrate consisting of a single crystal, and having a (111) crystal plane on a surface thereof.

According to the research conducted by the present inventors, it has been revealed that a deteriorated layer forms on a surface of a single crystal Ni substrate during surface polishing process and the like, and hence a normal (111) crystal plane does not appear on the surface.

In Patent Document 1, the surface of the polycrystal nickel base material is cleaned simply by a hydrogen plasma treatment for about 30 minutes, but it has been revealed that when such a condition is employed, a deteriorated layer formed on a polished surface of a single crystal nickel base material cannot be removed.

Based on the research of the present inventors, it has been revealed that to make a normal (111) crystal plane appear on the surface, it is necessary to perform a hydrogen plasma treatment with the base material heated to 1000°C or higher using a CVD apparatus.

In such a single crystal Ni substrate, the (111) crystal plane can be obtained by performing a hydrogen plasma treatment to remove a surface layer of a base material, the base material being obtained by slicing a single crystal nickel ingot in the <111> orientation, followed by surface-polishing.

Here, the single crystal nickel ingot may be a single crystal bulk material produced by Czochralski (CZ) method in which a seed crystal is dipped into a melt and then pulled up while rotating the crystal.

According to a second aspect of the invention, there is provided a method for producing a diamond substrate, comprising forming, using a CVD apparatus, a carbon solid solution and a diamond nucleus on a surface of the nickel substrate according to claim 1; and epitaxially growing a diamond layer.

A technique using a single crystal nickel substrate of the invention for heteroepitaxially growing a diamond layer on a surface thereof can refer to the process described in Patent Document 1.

### ADVANTAGEOUS EFFECTS OF INVENTION

A single crystal Ni substrate according to the invention has a (111) crystal plane on its surface, and hence, a highly oriented diamond layer can be heteroepitaxially grown by using the substrate.

In particular, by using a large-diameter single crystal Ni substrate of 4 inches or larger, large-diameter diamond substrates of 4 inches, 6 inches, and even 7 inches or larger can be obtained.

### BRIEF DESCRIPTION OF THE DRAWINGS

FIG. 1A illustrates a surface appearance and EBSD (electron backscatter diffraction) analysis results of a Ni base material immediately after purchase (Comparative Example), and FIG. 1B illustrates a surface appearance and EBSD analysis results of a Ni substrate obtained after removing a deteriorated layer (Invention).
FIG. 2 illustrates analysis results of the deteriorated layer by EDS (energy dispersive X-ray spectroscopy).
FIG. 3 illustrates an example of film formation with a CVD apparatus using a Ni base material having a deteriorated layer thereon.
FIG. 4 illustrates an example of heteroepitaxial growth of a diamond layer using the Ni substrate according to the invention.
FIG. 5 is a comparison table of physical properties of diamond, Si, Ir, and Ni.

### DESCRIPTION OF EMBODIMENTS

A single crystal nickel base material was obtained by slicing a single crystal Ni bulk material produced by a CZ method, and surface-polishing the resultant. A sample having a deteriorated layer on a surface of the single crystal nickel base material, and another sample from which this deteriorated layer had been removed by a hydrogen plasma treatment using a CVD apparatus were subjected to a heteroepitaxial growth test, which will now be described.

Herein, the sample having the deteriorated layer on its surface is referred to as a nickel base material, and the sample with the deteriorated layer removed is referred to as a nickel substrate for distinguishing these.

A surface of a purchased single crystal nickel base material was cleaned with acetone and ethanol, followed by a 10-minute ultrasonic cleaning using ultrapure water, and thus, a comparative example was obtained. A present invention sample was obtained by further performing a hydrogen plasma treatment using a CVD apparatus after the cleaning, so as to be comparatively evaluated.

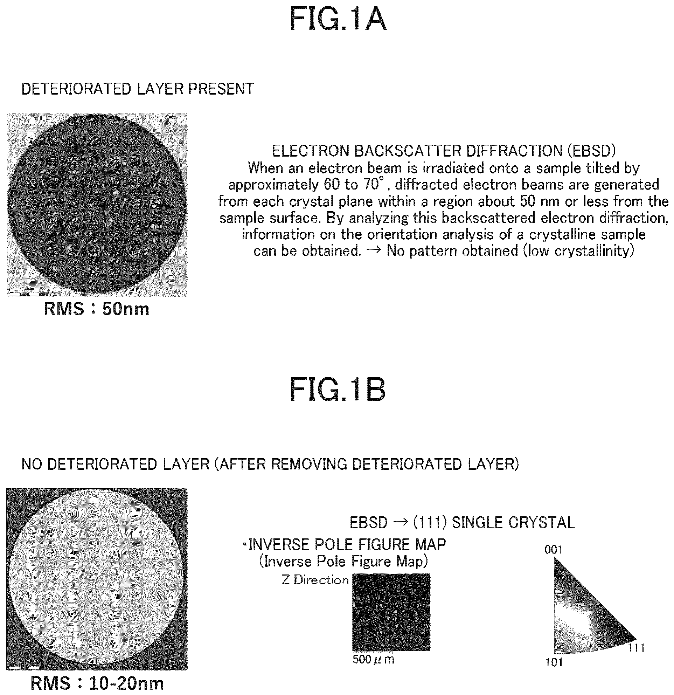

The evaluation was conducted by employing the following combination of conditions for the hydrogen plasma treatment:
(1) Input power (W): 1250, 1400, 1520
(2) Pressure (kPa): 30
(3) Hydrogen flow rate (sccm): 50
(4) Treatment time (hour): 0.5 h, 1.5 h, 3h, 5h
FIGS. 1A and 1B illustrate a surface appearance and EBSD (electron backscatter diffraction) analysis results of the Ni base material and the nickel substrate.

FIG. 1A illustrates the result of the comparative example having been subjected only to ultrasonic cleaning, and FIG. 1B illustrates the result of the present invention sample obtained by removing the deteriorated layer from the surface of the base material by the hydrogen plasma treatment.

The comparative example having the deteriorated layer had surface roughness (RMS) of about 50 nm, and was found, by the EBSD (electron backscatter diffraction) analysis, to have no crystal pattern on the surface thereof, and thus was revealed to be poor in crystallinity.

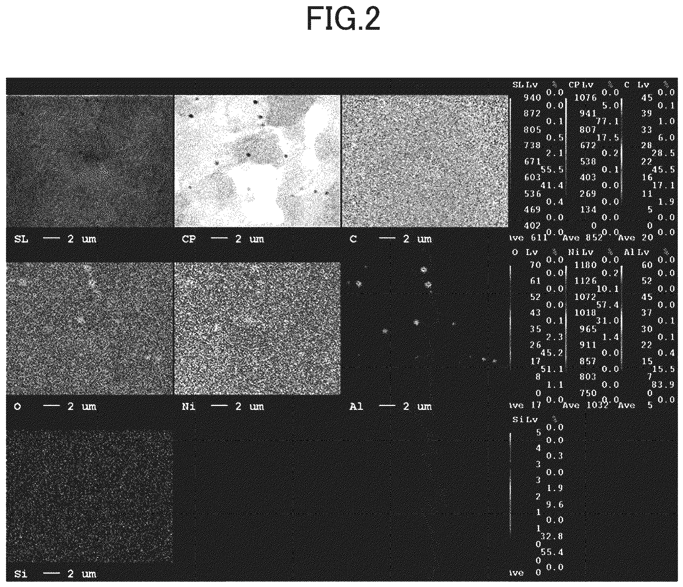

Results of surface analysis by energy dispersive X-ray spectroscopy (EDS) are illustrated in FIG. 2.

Impurities were present on the surface, and Al oxides presumed to be a component of an abrasive were also present on the surface.

In contrast, in the sample having been subjected to the hydrogen plasma treatment with an input power of 1250 W for 0.5 hours, the temperature of the base material reached 1230°C, and a (111) crystal plane appeared on the surface.

There partially was, however, a deteriorated layer.

Under conditions of the input power of 1400 W and 0.5 hours (temperature of the base material: 1300°C), a uniform (111) crystal plane was obtained.

When the hydrogen plasma treatment was conducted under conditions of the input power of 1400 W and 1.5 hours, 3 hours, or 5 hours, the temperature of the base material was 1300 to 1350°C, and a uniform (111) crystal plane was obtained in all the cases. When conditions of the input power of 1520 W and 0.5 hours were employed, the temperature of the base material was 1300°C, and a uniform (111) crystal plane was formed also in this case.

Besides, the surface roughness (RMS) was at a level of 10 to 20 nm.

From these findings, it was revealed that the temperature of the base material is an important factor for removing the deteriorated layer.

For removing the deteriorated layer present on the surface of a single crystal nickel base material, the temperature of the base material is at least 1200°C or more, suitably 1200 to 1350°C, and preferably 1300 to 1350°C.

Besides, the input power is 1250 to 1520 W, and preferably in a range of 1400 to 1520 W.

Figure 1B illustrates, for reference, an EBSD image of a sample prepared under conditions of the input power of 1400 W and 5 hours, wherein a (111) crystal plane appeared uniformly on the surface.

Next, the nickel base material having the deteriorated layer on the surface thereof, and the nickel substrate from which the deteriorated layer had been removed were used for conducting film formation evaluation using a CVD apparatus.

As a film formation method, a bias treatment (BEN: bias enhanced nucleation) was performed using 2.45 GHz microwaves under the following conditions:
(1) Input power (W): 700
(2) Pressure (kPa): 10
(3) Hydrogen flow rate (sccm): 50
(4) Methane concentration (%): 10
(5) Applied voltage (V): -350
(6) Treatment time (min): 25

Thus, a diamond nucleus was formed, and then a diamond layer was grown under the following conditions:
(1) Input power (W): 700
(2) Pressure (kPa): 10
(3) Hydrogen flow rate (sccm): 100
(4) Methane concentration (%): 2
(5) Treatment time (hour): 5

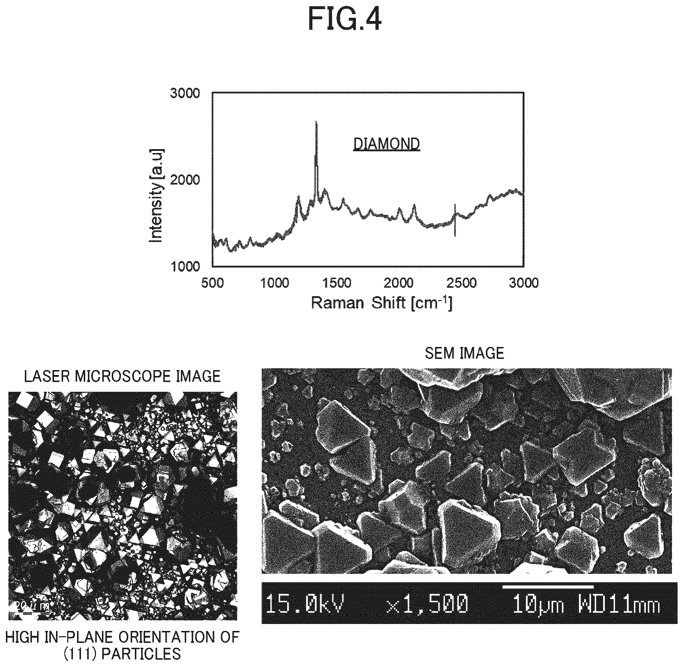

A Raman spectrum obtained with a Raman spectrophotometer, a laser microscope image, and an SEM image of a diamond layer obtained by the above-described process are illustrated in FIG. 4.

From the Raman spectrum, the formation of diamond was confirmed, and from the laser microscope image and SEM image, high in-plane orientation of (111) particles was revealed.

Next, the nickel base material from which the deteriorated layer had not been removed was used to perform the processes similar to those described above.

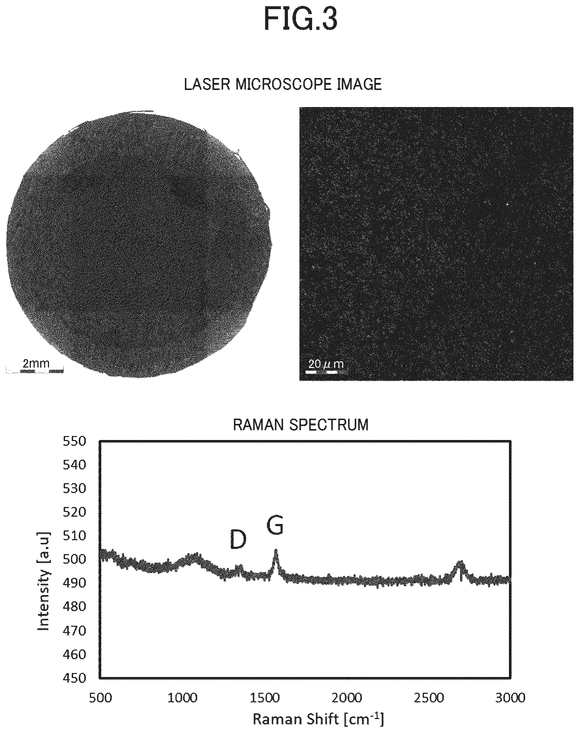

As a result, as illustrated in FIG. 3 of the external appearance, laser microscope image, and Raman spectrum, a graphite layer was formed, and no diamond layer could be confirmed.

Referring to these findings, by removing a deteriorated layer present on the surface of a single crystal nickel base material under specific conditions, a highly oriented diamond layer can be heteroepitaxially grown.

### INDUSTRIAL APPLICABILITY

According to the invention, a large-diameter single crystal Ni substrate can be obtained, based on which a large-diameter diamond substrate can be obtained.

## Claims

1. A nickel substrate to be used for heteroepitaxially growing a diamond layer, the nickel substrate consisting of a single crystal, and having a (111) crystal plane on a surface thereof.

2. A method for producing the nickel substrate according to claim 1, comprising obtaining the (111) crystal plane by performing a hydrogen plasma treatment to remove a surface layer of a base material, the base material being obtained by slicing a single crystal nickel ingot in <111> orientation, followed by surface-polishing.

3. The method for producing the nickel substrate according to claim 2, wherein the single crystal nickel ingot is a single crystal bulk material produced by Czochralski (CZ) method in which a seed crystal is dipped into a melt and then pulled up while rotating the crystal.

4. A method for producing a diamond substrate, comprising forming, using a CVD apparatus, a carbon solid solution and a diamond nucleus on a surface of the nickel substrate according to claim 1; and epitaxially growing a diamond layer.
